# EUROPÄISCHE PATENTANMELDUNG

(11) **EP 0 874 251 A2**
(43) Veröffentlichungstag der Anmeldung: **28.10.1998**
(21) Anmeldenummer: 98106632.7
(22) Anmeldetag: 09.04.1998
(51) Int. Cl.: G02B 6/00

(54) **Verfahren zum Herstellen einer Vorrichtung mit einem an einem Ende strukturierten Hohlraum**

(30) Priorität: 19.04.1997 DE 19716480
(71) Anmelder: Micronas Intermetall GmbH, 79108 Freiburg (DE)
(72) Erfinder: Igel, Günter, Dipl.-Ing., 79331 Teningen (DE); Mall, Martin, Dr. Dipl.-Phys., 79100 Freiburg (DE)
(74) Vertreter: Hornig, Leonore, Dr.

(57) **Zusammenfassung**

Die Erfindung betrifft ein Verfahren zum Herstellen einer Vorrichtung mit einem an einem Ende strukturierten Hohlraum 7. In einem Körper wird eine Vertiefung 4 ausgebildet, eine Maskierschicht 5 wird auf die Oberfläche des Körpers und die Vertiefung 4 aufgebracht, wobei die Maskierschicht 5 eine niedrigere Ätzrate als der Körper aufweist und in der Maskierschicht 5 in der Nähe der Vertiefung 4 eine Öffnung 6 ausgebildet wird. Ausgehend von der Öffnung 6 wird der Körper einem isotropen Ätzverfahren unterzogen, bei dem unterhalb der Maskierschicht 5 der Hohlraum 7 erzeugt wird, wobei die Maskierschicht 5 im wesentlichen erhalten bleibt und im Bereich der Vertiefung 4 eine in den Hohlraum 7 hineinragende Struktur 10 bildet.

## Beschreibung

Die Erfindung betrifft ein Verfahren zum Herstellen einer Vorrichtung mit einem an einem Ende strukturierten Hohlraum.

Eine solche Vorrichtung kann für verschiedene Anwendungen , insbesondere in der Mikrotechnik, eingesetzt werden. Sie kann als Sensor verwendet werden, indem die Struktur geeignet ausgebildet und gegebenenfalls mit einem Detektor versehen wird. Dazu kann die Struktur beispielsweise lichtdurchlässig zu optischen Untersuchungen oder als Membran für Druckmessungen ausgebildet werden. Die zu untersuchende Substanz wird dann in den Bereich der Struktur am Ende des Hohlraums eingebracht. Der Hohlraum kann auch zur Aufnahme van Gegenständen, beispielsweise von Lichtwellenleitern verwendet werden.

Die Herstellung einer derartigen Vorrichtungen ist aufwendig, da in dem Körper ein Hohlraum ausgebildet und entsprechend strukturiert werden muß.

Eine Vorrichtung zur Aufnahme eines Lichtwellenleiters ist aus der DE 44 46 509 bekannt. In einem Substrat werden V-förmige Nuten ausgebildet. Die Lichtwellenleiter werden in den V-förmigen Vertiefungen angeordnet. Um in der Nähe der Lichtwellenleiter elektrische Kontakte herzustellen, müssen aufwendige Beschichtungs- und Ätzverfahren durchgeführt werden.

Aus A. Heuberger, Mikromechanik, Springer Verlag 1991, Seite 432 ff. ist ebenfalls eine Vorrichtung zum Aufnehmen von Lichtwellenleitern bekannt. In einem Körper sind V-förmige Gräben ausgebildet, in denen die Lichtwellenleiter angeordnet werden. Zur Justierung der Lichtwellenleiter wird ein zweiter Körper mit V-förmigen Gräben auf den ersten Körper gelegt, so daß die Lichtwellenleiter in einer sandwichförmigen Struktur festgehalten werden. Die beiden Körper werden miteinander verbunden.

Die bekannten Vorrichtungen zum Aufnehmen von Lichtwellenleitern haben den Nachteil, daß, die Fixierung der Lichtwellenleiter am Körper aufwendig und schwierig ist. Zur Fixierung in der Vertikalen muß eine getrennte Abdeckung hergestellt und aufgebracht werden. Eine Justierung der Lichtwellenleiterenden in der Horizontalen gegenüber einer vorgegebenen Position ist nur mit großen Fehlertoleranzen möglich. Ferner ist die Auflagefläche der Lichtwellenleiter auf den V-förmigen Gräben gering, wodurch es zu mechanischen Spannungen im Lichtwellenleiter kommt. Das Anbringen von elektrischen Kontakten in der Nähe der Lichtwellenleiterenden ist aufwendig.

Der Erfindung liegt die Aufgabe zugrunde, ein Verfahren zu schaffen, mit dem eine Vorrichtung mit einem an einem Ende strukturierten Hohlraum einfach hergestellt werden kann.

Diese Aufgabe wird durch ein Verfahren gelöst, bei dem in einem Körper eine Vertiefung ausgebildet wird, eine Maskierschicht auf die Oberfläche des Körpers und die Vertiefung aufgebracht wird, wobei die Maskierschicht eine niedrigere Ätzrate als der Körper aufweist, in der Maskierschicht in der Nähe der Vertiefung eine Öffnung ausgebildet wird, und der Körper ausgehend von der Öffnung einem isotropen Ätzverfahren unterzogen wird, bei dem unterhalb der Maskierschicht ein Hohlraum erzeugt wird, wobei die Maskierschicht im wesentlichen erhalten bleibt und an dem Ende des Hohlraums im Bereich der Vertiefung eine in den Hohlraum hineinragende Struktur bildet.

Bei dem erfindungsgemäßen Verfahren wird durch Ätzen ein Hohlraum erzeugt. Der Hohlraum wird nach oben durch die Maskierschicht begrenzt. Der erzeugte Hohlraum erhält bei einem isotropen Ätzverfahren einen annähernd kreisförmigen Querschnitt. Die an einem Ende in den Hohlraum hineinragende Struktur entsteht aufgrund der in der Maskierschicht ausgebildeten Vertiefung beim Ätzen, da die Maskierschicht im wesentlichen erhalten bleibt. Wenn ein Gegenstand, insbesondere ein Lichtwellenleiter in den Hohlraum eingebracht wird, so hat dieser in dem Hohlraum eine große Auflagefläche, so daß geringere mechanischen Spannungen auftreten. Die Maskierschicht dient dann zur Justierung des Lichtwellenleiters. Einerseits wird der Lichtwellenleiter durch sie in der Vertikalen am Körper fixiert, so daß keine zusätzliche Abdeckung für den Lichtwellenleiter separat hergestellt und aufgebracht werden muß, und komplizierte Verfahrensschritte vermieden werden. Andererseits bildet die durch die Maskierschicht im Bereich der Vertiefung entstandene Struktur einen mechanischen Anschlag für den Lichtwellenleiter, so daß das Ende des Lichtwellenleiters in der Horizontalen sehr genau justiert werden kann. Hierzu wird der Lichtwellenleiter soweit in den Hohlraum eingeschoben, bis er am mechanischen Anschlag anliegt.

Gemäß einem bevorzugten Ausführungsbeispiel der Erfindung wird in der Maskierschicht auf beiden Seiten der Vertiefung eine Öffnung ausgebildet, wobei der Körper ausgehend von den Öffnungen dem Ätzverfahren so unterzogen wird, daß auf beiden Seiten der Vertiefung jeweils ein Hohlraum ausgebildet wird und die Maskierschicht im Bereich der Vertiefung eine zwischen die Hohlräume hineinragende Struktur bildet. Diese Struktur kann als Abstandshalter für in die Hohlräume eingeführete Gegenstände dienen. Ein derartiger Abstandshalter ist insbesondere vorteilhaft, wenn die Vorrichtung zur Aufnahme von Lichtwellenleitern benutzt wird, da dann die Enden von zwei sich einander gegenüberliegenden Lichtwellenleitern sehr genau zueinander justiert werden können. Dies ist wesentlich, um eine wirksame Kopplung zwischen zwei Lichtwellenleitern zu erreichen. Die Effektivität der Kopplung zwischen Lichtwellenleitern nimmt stark mit dem normierten Abstand, d.h. dem Verhältnis des Abstandes zum Durchmesser des Lichtwellenleiters, ab. Dies ist beispielsweise in H. Reichel, Mikrosystem Technologies, 1992, VDE Verlag, Seite 301 ff. ausgeführt. Da mit den Methoden der Mikrotechnik erfindungsgemäß ein Abstandshalter für einen sehr geringen Abstand von den Enden zweier sich einander gegenüberliegender Lichtwellenleiter erzielt werden kann, kann eine wirksame Kopplung zwischen zwei Lichtwellenleitern erreicht werden.

Gemäß einem bevorzugten Ausführungsbeispiel der Erfindung werden in der Maskierschicht mehrere auf einer Linie liegende Öffnungen ausgebildet, deren Abstand so gewählt wird, daß bei dem Ätzverfahren auf wenigstens einer Seite der Vertiefung ein durchgehender Hohlraum entsteht. Dabei überlappen bei dem Ätzverfahren die Ätzfronten, die sich ausgehend von nebeneinanderliegenden Öffnungen in den Körper ausbreiten. Hierdurch wird ein langer Hohlraum mit einem gleichmäßigen Querschnitt ausgebildet. In diesem können Lichtwellenleiter zuverlässig fixiert werden.

Gemäß einem anderen Ausführungsbeispiel der Erfindung werden die Öffnungen in der Maskierschicht spaltförmig ausgebildet, wobei ihre Längsachse in Richtung des jeweils zu erzeugenden Hohlraumes verläuft.

Gemäß einer Weiterbildung der Erfindung kann ein fester Gegenstand, insbesondere ein Lichtwellenleiter, der in den Hohlraum eingebracht wird, im Bereich der Öffnungen fixiert werden. Das Fixieren kann mechanisch, beispielsweise durch Anbringen einer Feder oder chemisch, beispielsweise durch Kleben oder durch Bedampfen des Mantels des Lichtwellenleiters mit einem Stoff erfolgen, welcher eine Verbindung mit diesem und der Maskierschicht eingeht.

Gemäß einem weiteren Ausführungsbeispiel der Erfindung kann ein gasförmiges, flüssiges oder solides Material durch eine oder mehrere Öffnungen in der Maskierschicht in den Bereich der Vertiefung eingebracht werden. Es können dann Eigenschaften des eingebrachten Materials, beispielsweise durch Chromatographie, gemessen werden. Mit diesem Verfahren können sehr kleine Mengen in den Bereich der Vertiefung am Ende eines oder zweier Lichtwellenleiter eingeschlossen werden, so daß spezielle Eigenschaften von sehr kleinen Mengen, beispielsweise Tropfen einer Flüssigkeit, geniessen werden können. Es kann auch ein Pulver oder ein Draht, zur Untersuchung eingebracht werden.

Elektrische Kontaktanschlüsse können auf der Maskierschicht einfach ausgebildet werden, weil die Oberfläche des Körpers nahezu eben bleibt. Dadurch ist es möglich, die Kontaktanschlüsse ganz in der Nähe von in den Hohlraum eingebrachten Gegenständen, beispielsweise von Lichtwellenleitern anzubringen. Dies ist insbesondere bei optoelektronischen Elementen vorteilhaft.

Gemäß einem weiteren Ausführungsbeispiel der Erfindung kann die Struktur mit einer Membran in der Vertiefung ausgebildet werden. Die Vorrichtung kann dann beispielsweise als Drucksensor verwendet werden. Die Maskierschicht kann im Bereich der Vertiefung zum Ausbilden der Struktur aus einem anderen Material gebildet werden als außerhalb dieses Bereiches. Beispielsweise kann ein magnetisch aktives Material verwendet werden. Dadurch entsteht eine Membran, die mittels eines Magneten bewegt werden kann. Ferner kann die Struktur im Bereich der Vertiefung lichtdurchlässig ausgebildet werden. In diesem Fall kann ein in das Innere der Vorrichtung eingebrachtes Material durch Licht angeregt werden, oder es kann durch dieses Material gestreutes Licht gemessen werden. Es kann ein aktives oder ein passives Element im Bereich der Struktur vorgesehen werden. Wenn die Struktur im Bereich der Vertiefung lichtdurchlässig ist, kann ein optischer Sensor angeordnet werden, mit dem Änderungen in der Intensität oder der Phasenlage des Lichtes gemessen werden können. Das Zuführen bzw. Wegführen von Licht kann durch in die Hohlräume eingebrachte Lichtwellenleiter erfolgen. Dann dient die Struktur als Abstandshalter.

Gemäß einem Ausführungsbeispiel der Erfindung kann als Substrat ein Halbleiterwafer verwendet werden. Auf dem Halbleiterwafer können weitere Strukturen ausgebildet werden. Es können mit herkömmlichen Halbleitertechnologieverfahren Kontakte, elektronische Strukturen und Schaltungsanordnungen auf dem Halbleiterwafer erzeugt werden. Die Maskierschicht kann aus Aluminium, die Ätzstoppschicht aus Siliziumoxid gebildet werden. Auf die Siliziumoxidschicht kann dann ein anderes Material als das Halbleitermaterial aufgebracht werden. Das Material wird abhängig von seinen Ätzeigenschaften und von dem gewünschten Durchmesser der Hohlräume gewählt.

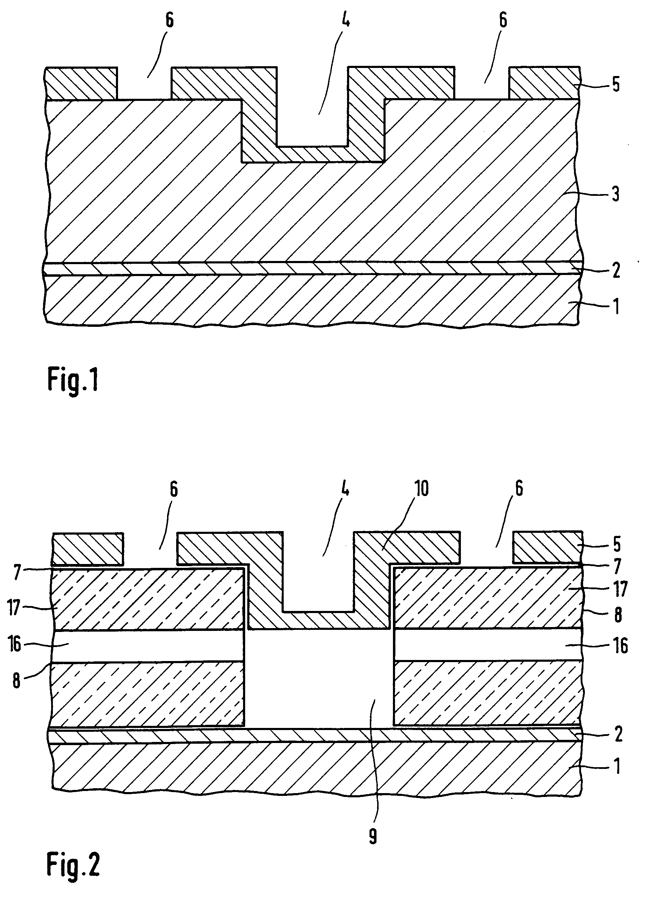

Im folgenden wird die Erfindung anhand der Figur näher erläutert.
Es zeigen Fig. 1 ein Ausführungsbeispiel einer nach dem erfindungsgemäßen Verfahren hergestellten Vorrichtung und
Fig. 2 bis 4 Ausführungsbeispiele von nach dem erfindungsgemäßen Verfahren hergestellten Vorrichtungen zum Aufnehmen von Lichtwellenleitern.

Im folgenden wird das erfindungsgemäße Verfahren anhand des in der Figur 1 gezeigten Ausführungsbeispiels beschrieben. Auf einen Halbleiterwafer 1 wird eine Ätzstoppschicht 2 aufgebracht. Der Halbleiterwafer 1 kann ein Siliziumwafer und die Ätzstoppschicht eine Siliziumoxidschicht sein. Auf die Ätzstoppschicht 2 wird eine Schicht 3 aus einem Material aufgebracht, das eine höhere Ätzrate als die Ätzstoppschicht 2 hat. Sie kann beispielsweise aus Silizium bestehen. In die Schicht 3 wird eine Vertiefung 4 eingebracht. Die Schicht 3 und die Vertiefung 4 werden mit einer Maskierschicht 5 versehen. In der Maskierschicht 5 werden Öffnungen 6 ausgebildet. Ausgehend von den Öffnungen 6 wird der Halbleiterwafer 1 einem isotropen Ätzverfahren unterzogen. Bei diesem Ätzverfahren wird die Schicht 3 entfernt. Es entstehen Hohlräume 7, in welche später ein beliebiges Material oder ein geeigneter Gegenstand eingeführt werden kann. Die Maskierschicht 5 und die Ätzstoppschicht 2 bilden bei dem Ätzverfahren die räumliche Begrenzung für die Hohlräume 7. Die Maskierschicht 5 bildet im Bereich der Vertiefung 4 einen Struktur, die zwischen die Hohlräume 7 hineinragt. Die Struktur kann als Abstandshalter von in die Hohlräume eingeführten Gegenständen, beispielsweise von Lichtwellenleitern 8 dienen.

In Fig. 2 ist dies am Beispiel von Lichtwellenleitern 8 gezeigt. Diese sind so weit in die Hohlräume 7 eingeführt, bis sie an dem Abstandshalter 4 anliegen. Dadurch ist der Abstand, den die Enden der Lichtwellenleiter 8, die jeweils einen Kern 16 und einen Mantel 17 aufweisen, voneinander haben, durch den Querschnitt der Vertiefung 4 definiert. Da die Halbleiterwafer mit Mikrotechnologie bearbeitet werden können, kann dieser Abstand sehr klein sein und sehr genau festgelegt werden. Damit ist die Effektivität der Kopplung der Kerne 16 der Lichtwellenleiter 8 gut einstellbar.

Die in Fig. 2 gezeigte Vorrichtung kann zur Kopplung von zwei Lichtwellenleitern 8 aneinander verwendet werden. Es können selbstverständlich mehrere derartige Vorrichtungen aneinander gesetzt werden. Die Vorrichtung kann auch als Sensor verwendet werden. Dabei wird der Bereich 9 unterhalb der Vertiefung 4 als Meßraum verwendet. Es kann dort ein zu untersuchendes Material, welches gasförmig, flüssig oder solid sein kann, eingebracht werden. Der Abstandshalter 4 kann zu dem gewünschten Zweck entsprechend, geeignet ausgebildet werden. Er kann etwa aus einem durchlässigen Material bestehen.

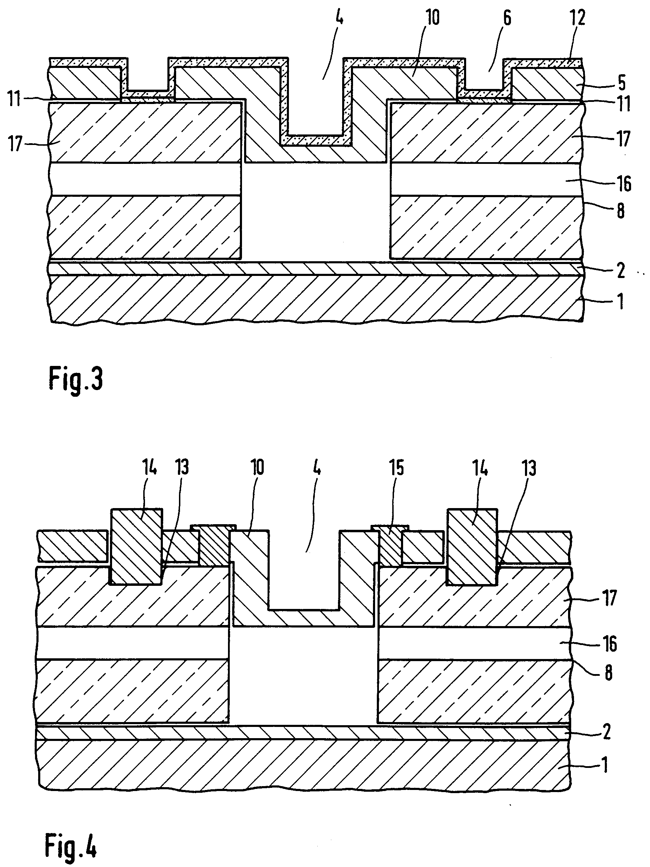

Die Lichtwellenleiter 8 können in den Hohlräumen 7 fixiert werden. In Fig. 3 ist hierzu ein Ausführungsbeispiel gezeigt, bei dem in den Öffnungen 6 eine Haftschicht 11 auf den Mantel 17 des jeweiligen Lichtwellenleiters 8 aufgebracht ist. Auf der Oberfläche der Maskierschicht 5 und der Haftschicht 11 ist eine Fixierschicht 12 aufgebracht, so daß eine feste Verbindung zwischen dem Mantel 17 des jeweiligen Lichtwellenleiters 8 und der Maskierschicht 5 hergestellt wird.

Fig. 4 zeigt ein weiteres Ausführungsbeispiel einer nach dem erfindungsgemäßen Verfahren hergestellten Vorrichtung. Die Lichtwellenleiter 8 sind in den Hohlräumen 7 dadurch befestigt, daß in ihrem Mantel 17 jeweils Vertiefungen 13 ausgebildet sind, in welche Befestigungszapfen 14 eingreifen. Zudem sind an den Enden der Lichtwellenleiter 8 elektrische Kontaktelemente 15 ausgebildet. Diese werden mit in der Halbleitertechnologie üblichen Verfahren hergestellt.

## Patentansprüche

1. Verfahren zum Herstellen einer Vorrichtung mit einem an einem Ende strukturierten Hohlraum (7), bei dem in einem Körper eine Vertiefung (4) ausgebildet wird, eine Maskierschicht (5) auf die Oberfläche des Körpers und die Vertiefung (4) aufgebracht wird, wobei die Maskierschicht (5) eine niedrigere Ätzrate als der Körper aufweist, in der Maskierschicht (5) in der Nähe der Vertiefung (4) eine Öffnung (6) ausgebildet wird, und der Körper ausgehend von der Öffnung (6) einem isotropen Ätzverfahren unterzogen wird, bei dem unterhalb der Maskierschicht (5) der Hohlraum (7) erzeugt wird, wobei die Maskierschicht (5) im wesentlichen erhalten bleibt und an dem Ende des Hohlraums (7) im Bereich der Vertiefung (4) eine in den Hohlraum (7) hineinragende Struktur (10) bildet.

2. Verfahren nach Anspruch 1, dadurch gekennzeichnet, daß in der Maskierschicht (5) auf beiden Seiten der Vertiefung (4) eine Öffnung (6) ausgebildet wird, wobei der Körper ausgehend von den Öffnungen (6) dem Ätzverfahren so unterzogen wird, daß auf beiden Seiten der Vertiefung (4) jeweils ein Hohlraum (7) zur Aufnahme eines Lichtwellenleiters (8) ausgebildet wird und die Maskierschicht (5) im Bereich der Vertiefung (4) eine zwischen die Hohlräume (7) hineinragende Struktur (10) bildet.

3. Verfahren nach Anspruch 1 oder 2, dadurch gekennzeichnet, daß in der Maskierschicht (5) mehrere auf einer Linie liegende Öffnungen (6) ausgebildet werden, deren Abstand so gewählt wird, daß bei dem Ätzverfahren auf wenigstens einer Seite der Vertiefung (4) ein durchgehender, entlang der Linie verlaufender Hohlraum (7) entsteht.

4. Verfahren nach einem der vorangehenden Ansprüche, dadurch gekennzeichnet, daß die Öffnungen (6) in der Maskierschicht (5) spaltförmig ausgebildet werden, wobei ihre Längsachse in Richtung des jeweils zu erzeugenden Hohlraumes (7) verläuft.

5. Verfahren nach einem der vorangehenden Ansprüche, dadurch gekennzeichnet, daß in dem Körper eine Ätzstoppschicht (2) so ausgebildet wird, daß sie beim Ätzvorgang eine Begrenzung der zu erzeugenden Hohlräume (7) zum Inneren des Körpers hin bildet.

6. Verfahren nach einem der vorangehenden Ansprüche, dadurch gekennzeichnet, daß der Lichtwellenleiter (8) im Bereich der Öffnungen (6) fixiert wird.

7. Verfahren nach einem der vorangehenden Ansprüche, dadurch gekennzeichnet, daß ein gasförmiges, flüssiges oder solides Material durch eine Öffnung in der Maskierschicht (5) in den Bereich der Vertiefung (13) eingebracht wird.

8. Verfahren nach einem der vorangehenden Ansprüche, dadurch gekennzeichnet, daß elektrische Kontaktanschlüsse (15) auf der Maskierschicht (5) ausgebildet werden.

9. Verfahren nach einem der vorangehenden Ansprüche, dadurch gekennzeichnet, daß die Struktur (10) mit einer Membran in der Vertiefung (4) ausgebildet wird.

10. Verfahren nach einem der vorangehenden Ansprüche, dadurch gekennzeichnet, daß die Maskierschicht (5) im Bereich der Vertiefung (4) zum Ausbilden der Struktur (10) aus einem anderen Material gebildet wird als außerhalb dieses Bereichs.

11. Verfahren nach einem der vorangehenden Ansprüche, dadurch gekennzeichnet, daß die Struktur (10) im Bereich der Vertiefung (4) durchlässig ausgebildet wird.

12. Verfahren nach einem der vorangehenden Ansprüche, dadurch gekennzeichnet, daß im Bereich der Struktur (10) ein aktives Element vorgesehen wird.

13. Verfahren nach einem der vorangehenden Ansprüche, dadurch gekennzeichnet, daß im Bereich der Struktur (10) ein passives Element vorgesehen wird.

14. Verfahren nach einem der vorangehenden Ansprüche, dadurch gekennzeichnet, daß als Substrat ein Halbleiterwafer (1) verwendet wird.

15. Verfahren nach Anpruch 13, dadurch gekennzeichnet, daß auf dem Halbleiterwafer (1) weitere Strukturen ausgebildet werden.
